# EUROPÄISCHE PATENTSCHRIFT

(11) **EP 0 996 320 B1**
(45) Veröffentlichungstag und Bekanntmachung des Hinweises auf die Patenterteilung: **22.01.2003**
(21) Anmeldenummer: 99119573.6
(22) Anmeldetag: 02.10.1999
(51) Int. Cl.: H05K 3/28

(54) **Platine mit auf beiden Seiten angeordneten Leiterbahnen**
Double sided circuit board
Circuit imprimé double face

(30) Priorität: 15.10.1998 DE 19847537
(43) Veröffentlichungstag der Anmeldung: 26.04.2000
(73) Patentinhaber: Siemens Aktiengesellschaft, 80333 München (DE)
(72) Erfinder: Kallweit, Gerhard, 60528 Frankfurt (DE)

(56) Entgegenhaltungen:
- EP-A- 0 549 116
- US-A- 5 252 858

## Beschreibung

Die Erfindung betrifft eine Platine mit auf beiden Seiten angeordneten Leiterbahnen und mit einem die Leiterbahnen verbindenden, die Platine in einer Bohrung durchdringenden Leitelement, wobei die Platine als Teilbereich eines abgedichteten Gehäuses, insbesondere für einen magnetisch passiven Positionssensor zur Ermittlung eines Füllstandes an Kraftstoff in einem Kraftstoffbehälter eines Kraftfahrzeuges, vorgesehen ist.

Eine solche Platine ist beispielsweise aus der DE 196 48 539 A1 als Seitenwand eines Gehäuses für einen magnetisch passiven Positionssensor bekannt. Hierbei ist die Platine als Keramiksubstrat gestaltet. Das Leitelement kann beispielsweise ein Niet sein oder aus in die Bohrung eingeschmolzenem Lotmaterial bestehen und dient zur Weiterleitung von Signalen eines im Gehäuse angeordneten Widerstandsnetzwerks zu außerhalb des Gehäuses angeordneten Anschlußkontakten. Das Widerstandsnetzwerk und die Anschlußkontakte werden bei der bekannten Platine an den Leiterbahnen angeschlossen. Das Leitelement läßt sich meist paßgenau in die Bohrung einsetzen. Zur dauerhaften Funktion des Positionssensors muß zumindest die an der Außenseite des Gehäuses angeordnete Leiterbahn gegen chemische Einflüsse geschützt werden. Die Leiterbahn wird deshalb meist aus einer Silber-Palladium-Legierung gefertigt.

Nachteilig bei der bekannten Platine ist, daß der Bereich der Bohrung nicht zuverlässig abgedichtet ist. Insbesondere entsteht bei Temperaturwechseln und hierdurch hervorgerufene unterschiedliche Ausdehnungen der Platine und des Leitelements ein Spalt, durch den Gase und Flüssigkeiten in das Gehäuse eindringen können.

Der Erfindung liegt das Problem zugrunde, eine Platine der eingangs genannten Art so zu gestalten, daß sie gegen eine Durchdringung von Gasen oder Flüssigkeiten zuverlässig abgedichtet ist.

Dieses Problem wird erfindungsgemäß dadurch gelöst, daß ein an das Leitelement angrenzender Bereich zumindest einer Seite der Platine und das Leitelement von einer glashaltigen Schicht überdeckt sind.

Durch diese Gestaltung der Platine führt ein Spalt zwischen dem Leitelement und der Bohrung nicht zu einer Undichtigkeit, da der Spalt von der glashaltigen Schicht abgedichtet ist. Die Platine eignet sich daher als Seitenwand eines gegen das umgebende Medium abgedichteten Gehäuses. Zur Herstellung der glashaltigen Schicht kann beispielsweise eine Glasstaub, Harz und organisches Lösungsmittel enthaltende Paste auf die Platine aufgetragen werden. Anschließend wird die Paste eingebrannt, bis das Lösungsmittel und/oder das Harz verdampft. Bei der aus Keramik gefertigten Platine kann die Paste auch erwärmt werden, bis die Bohrung von einer geschlossenen Glasschicht überzogen ist. Entsprechend der Zusammensetzung der Paste und des Einbrennvorgangs läßt sich die Platine gegen ein nahezu beliebiges Medium zuverlässig abdichten.

Zur weiteren Verbesserung der Dichtheit der erfindungsgemäßen Platine trägt es bei, wenn die glashaltige Schicht Metalloxide enthält. Weiterhin führen Metalloxide zu einer Verbesserung der Fließeigenschaften der Paste beim Einbrennen.

Häufig werden Leiterbahnen von Platinen mit einer Dielektrikumspaste beschichtet, um beispielsweise eine Beschädigung von elektronischen Bauteilen durch elektrostatische Entladungen zu verhindern. Da die glashaltige Schicht elektrischen Strom nicht leitet, kann auf die Beschichtung mit der Dielektrikumspaste verzichtet werden. Elektronische Bauteile werden jedoch im Fertigungsprozeß vor dem Einbrennen der glashaltigen Schicht zuverlässig vor einer elektrostatischen Entladung geschützt, wenn zwischen dem Leitelement und der glashaltigen Schicht eine aus einer Dielektrikumspaste bestehende Schicht angeordnet ist.

Die glashaltige Schicht könnte beispielsweise vollständig aus geschmolzenem Glas bestehen. Die glashaltige Schicht hat gemäß einer anderen vorteilhaften Weiterbildung der Erfindung besonders zuverlässige Haftungseigenschaften, wenn sie ein Bindemittel aus Harz enthält. Weiterhin verleiht das Harz der glashaltigen Schicht eine Elastizität, so daß Temperaturwechsel nicht zu Rissen in der glashaltigen Schicht führen können. Ein weiterer Vorteil dieser Gestaltung besteht darin, daß sich durch das Harz eine Einbrenntemperatur der glashaltigen Schicht verringern läßt.

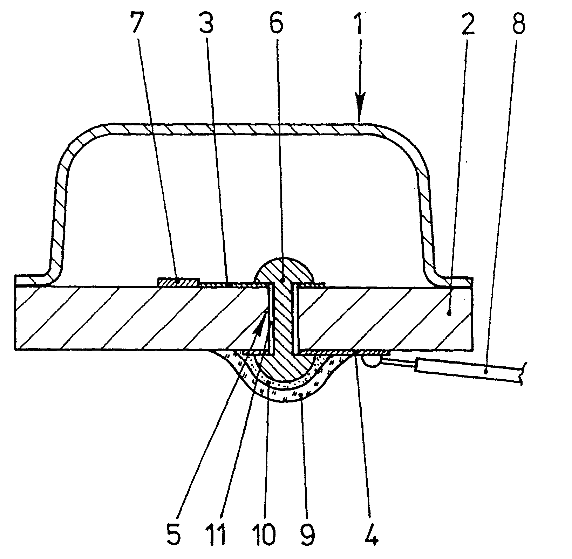

Die Erfindung läßt zahlreiche Ausführungsformen zu. Zur weiteren Verdeutlichung ihres Grundprinzips ist eine davon in der Zeichnung dargestellt und wird nachfolgend beschrieben. Diese zeigt in einer einzigen Figur eine Schnittdarstellung durch eine erfindungsgemäße, als Seitenwand eines Gehäuses 1 eingesetzte Platine 2. Die Platine 2 kann beispielsweise Teil eines magnetisch passiven Positionssensors sein und in einem Füllstandssensor in einem Kraftstoffbehälter eines Kraftfahrzeuges eingesetzt werden.

Die Platine 2 ist aus Keramik gefertigt und hat auf beiden Seiten jeweils Leiterbahnen 3, 4, die im Bereich einer Bohrung 5 durch ein Leitelement 6 miteinander verbunden sind. Das Leitelement 6 kann beispielsweise ein Niet sein oder aus Lotmaterial bestehen. Die auf der Innenseite des Gehäuses 1 angeordnete Leiterbahn 3 ist mit einer Widerstandsbahn 7 verbunden. Die an der Außenseite des Gehäuses 1 angeordnete Leiterbahn 4 dient zum Anschluß einer elektrischen Leitung 8. Da bei der als Teil des Füllstandssensors für einen Kraftstoffbehälter eingesetzten Platine 2 die Außenseite des Gehäuses 1 mit Kraftstoff in Berührung kommt, ist diese Leiterbahn 4 aus einem kraftstoffbeständigen Material wie beispielsweise einer Silber-Palladium-Legierung gefertigt.

Der Bereich des Leitelements 6 außerhalb des Gehäuses 1 und der daran angrenzende Bereich der Platine 2 sind mit einer glashaltigen Schicht 9 überzogen. Zwischen der glashaltigen Schicht 9 und dem Leitelement 6 sowie den angrenzenden Bereichen der Platine 2 ist eine Schicht 10 einer Dielektrikumspaste angeordnet. Diese Schicht 10 dient zum Schutz von nicht dargestellten elektronischen Bauteilen innerhalb des Gehäuses 1 während des Fertigungsprozesses. Die glashaltige Schicht 9 überdeckt das Leitelement 6 und den von der Schicht 10 der Dielektrikumspaste überdeckten Bereich der Platine 2. Hierdurch ist ein zwischen der Bohrung 5 und dem Leitelement 6 befindlicher Spalt 11 dauerhaft abgedichtet.

Zur Abdichtung der Platine wird nach einem Einsetzen des Leitelements 6 in die Bohrung 5 die Schicht 10 Dielektrikumspaste auf die vorgesehenen Stellen gedruckt. Anschließend wird diese Schicht 10 eingebrannt. Nach einem Abkühlen der Platine 2 wird eine Paste aus Glaspulver, Metalloxiden und in einem Lösungsmittel gelösten Harzen auf den Bereich, der von der glashaltigen Schicht 9 überzogen werden soll, aufgebracht und anschließend eingebrannt. Die Beschaffenheit der hierdurch entstehenden Schicht 9 läßt sich über die Einbrenntemperatur und die Einbrenndauer sowie die Zusammensetzung der Paste einstellen. Das Aufbringen der Dielektrikumspaste und der Glaspulverpaste kann beispielsweise im Siebdruckverfahren erfolgen.

## Patentansprüche

1. Platine mit auf beiden Seiten angeordneten Leiterbahnen und mit einem die Leiterbahnen verbindenden, die Platine in einer Bohrung durchdringenden Leitelement, wobei die Platine als Teilbereich eines abgedichteten Gehäuses, insbesondere für einen magnetisch passiven Positionssensor zur Ermittlung eines Füllstandes an Kraftstoff in einem Kraftstoffbehälter eines Kraftfahrzeuges, vorgesehen ist, **dadurch gekennzeichnet, daß** ein an das Leitelement (6) angrenzender Bereich zumindest einer Seite der Platine (2) und das Leitelement (6) von einer glashaltigen Schicht (9) überdeckt sind.

2. Platine nach Anspruch 1, **dadurch gekennzeichnet, daß** die glashaltige Schicht (9) Metalloxide enthält.

3. Platine nach Anspruch 1 oder 2, **dadurch gekennzeichnet, daß** zwischen dem Leitelement (6) und der glashaltigen Schicht (9) eine aus einer Dielektrikumspaste bestehende Schicht (10) angeordnet ist.

4. Platine nach zumindest einem der vorhergehenden Ansprüche, **dadurch gekennzeichnet, daß** die glashaltige Schicht (10) ein Bindemittel aus Harz enthält.

## Claims

1. Printed circuit board with conductor tracks arranged on both sides and with a conducting element connecting the conductor tracks and passing through the printed circuit board in a drilled hole, the printed circuit board being provided as a subregion of a sealed housing, in particular for a magnetically passive position sensor for determining a filling level of fuel in a fuel tank of a motor vehicle, **characterized in that** a region adjacent to the conducting element (6), at least of one side of the printed circuit board (2), and the conducting element (6) are covered by a vitreous layer (9).

2. Printed circuit board according to Claim 1, **characterized in that** the vitreous layer (9) contains metal oxides.

3. Printed circuit board according to Claim 1 or 2, **characterized in that** a layer (10) comprising a dielectric paste is arranged between the conducting element (6) and the vitreous layer (9).

4. Printed circuit board according to at least one of the preceding claims, **characterized in that** the vitreous layer (10) contains a binder of resin.

## Revendications

1. Platine comportant des pistes conductrices placées sur ses deux côtés et un élément conducteur traversant la platine par un trou et reliant les pistes conductrices, la platine étant prévue comme zone partielle d'un boîtier rendu étanche, en particulier pour un détecteur de position magnétiquement passif pour la détermination d'un niveau de carburant dans un réservoir de carburant d'un véhicule à moteur, **caractérisé en ce qu'**une zone adjacente à l'élément conducteur (6) sur au moins un côté de la platine (2) ainsi que l'élément conducteur (6) sont recouverts d'une couche (9) contenant du verre.

2. Platine selon la revendication 1, **caractérisée en ce que** la couche (9) contenant du verre contient des oxydes métalliques.

3. Platine selon la revendication 1 ou 2, **caractérisée en ce que**, entre l'élément conducteur (6) et la couche (9) contenant du verre, est placée une couche (10) constituée par une pâte diélectrique.

4. Platine selon l'une au moins des revendications précédentes, **caractérisée en ce que** la couche (10) contenant du verre contient un liant en résine.
